# EUROPÄISCHE PATENTSCHRIFT

(11) **EP 1 118 258 B1**
(45) Veröffentlichungstag und Bekanntmachung des Hinweises auf die Patenterteilung: **05.03.2003**
(21) Anmeldenummer: 99953699.8
(22) Anmeldetag: 02.09.1999
(51) Int. Cl.: H05K 13/02, H05K 13/04, H05K 13/08

(54) **VERFAHREN ZUR RÜSTUNGSKONTROLLE AN BESTÜCKAUTOMATEN**
METHOD FOR CHECKING COMPONENTS IN PICK-AND-PLACE ROBOTS
PROCEDE DE CONTROLE DE LA PRESENCE DE COMPOSANTS ADEQUATS DANS DES MACHINES A POSER DES COMPOSANTS

(30) Priorität: 29.09.1998 DE 19844661
(43) Veröffentlichungstag der Anmeldung: 25.07.2001
(73) Patentinhaber: Siemens Production and Logistics Systems AG, 90475 Nürnberg (DE)
(72) Erfinder: STANZL, Harald, D-81476 München (DE); PRITTMANN, Jochen, D-81379 München (DE)
(74) Vertreter: Berg, Peter, Dipl.-Ing.
(86) Internationale Anmeldenummer: DE9902786
(87) Internationale Veröffentlichungsnummer: WO00019794

(56) Entgegenhaltungen:
- US-A- 5 099 522
- US-A- 5 667 129

## Beschreibung

Die Erfindung bezieht sich auf ein Verfahren zur Rüstungskontrolle an Bestückautomaten.

Bei der automatischen Bestückung von Substraten (beispielsweise Leiterplatten oder Keramiksubstraten) mit SMD-Bauelementen (SMD = Surface Mounted Device) werden die einzelnen Bauelemente mittels eines Bestückkopfes aus einer Zuführeinrichtung entnommen und dann in einer vorgegebenen Lage auf dem Substrat positioniert.

Die Kontrolle, ob die richtigen Bauelemente in den Zuführeinrichtungen bereit gestellt (gerüstet) sind, wird bisher manuell durch den Bediener vorgenommen. Für Zuführeinrichtungen in Form von mit Bauelemente-Taschen versehenen Bändern ist es bekannt, die Spulenkörper, um die die Bänder im Lieferzustand gewickelt sind, mit Barcodes auszustatten. Diese Barcodes werden vor dem Einbau in den Bestückautomaten ausgelesen und erlauben somit eine gewisse Kontrolle über die Anwesenheit der richtigen Bauelemente. Allerdings wird bei einer derartigen Rüstungskontrolle nur der Spulenkörper überprüft; ob Band und Spulenkörper zueinander passen, muß separat sichergestellt sein.

Die Druckschriften US-A-5 667 129 und US-A-5 099 522 zeigen weitere Verfahren zur Erkennung von Bauelementen.

Es ist daher die Aufgabe der Erfindung ein Verfahren anzugeben, mit dem die Kontrolle der Rüstung eines Bestückautomaten automatisch erfolgt.

Die Aufgabe wird erfindungsgemäß durch ein Verfahren der eingangs genannten Art mit den Merkmalen des Anspruchs 1 gelöst.

In vorteilhafter Weise nimmt eine Kamera ein Bild der Oberfläche des zu bestückenden Bauelementes in der Zuführeinrichtung auf, bevor es der Bestückkopf aus der Zuführeinrichtung entnimmt. Der Begriff Oberfläche umfaßt dabei auch von oben zu erkennende Anschlüsse des Bauelementes. Eine nachgeschaltete Bildauswerteeinheit vergleicht das Bild mit einem vorher abgespeicherten Muster des Bauelementes und nur bei einer Übereinstimmung des Bildes mit dem Muster wird das Bauelement bestückt. Diese Überprüfung erfolgt automatisch durch die Kamera und die Bildauswerteeinheit. Sie ist nicht abhängig vom Bediener und wertet direkt das Bauelement und nicht einen zwischengeschalteten Träger wie beispielsweise einen Spulenkörper aus.

In vorteilhafter Weise läßt sich gemäß Anspruch 2 auch die Position des Bauelementes in der Zuführeinrichtung durch den Vergleich des Bildes mit dem Muster bestimmen. Dadurch kann der Bestückkopf vor dem Aufnehmen des Bauelementes bereits in eine für das Aufnehmen günstige Position gebracht werden. Dieses Verfahren eignet sich auch besonders für Bauelemente, die sich in zu groß bemessenen Taschen befinden, so daß ihre Position zunächst nur ungenau bekannt ist.

In einer bevorzugten Ausführungsform nach Anspruch 3 enthält das abgespeicherte Muster Schriftzüge wie Firmennamen, Firmenlogos oder Typenbezeichnungen, die mit Hilfe der Bildauswerteinheit auf dem Bild des Bauelementes zur Rüstungskontrolle identifiziert werden.

Mithilfe der Bildauswerteeinheit können gemäß Anspruch 4 oder 5 auch auf der Oberfläche des Bauelementes angebrachte kodierte Kennzeichen (Barcodes, Matrixcodes) oder Markierungen (Funktions- oder Positionsmarkierungen) identifiziert werden.

Bei von oben erkennbaren Anschlüssen sind diese gemäß Anspruch 6 ebenfalls im Muster enthalten, um mit deren Hilfe die richtige Rüstung oder die richtige Position der Bauelemente zu identifizieren.

In vorteilhafter Weise wird gemäß Anspruch 7 die am Bestückkopf angebrachte Kamera verwendet, die zusätzlich für die Erkennung von Substratmarkierungen zur Lageerkennung des Substrats eingesetzt wird.

Die Erfindung wird nun anhand eines in den Figuren der Zeichnung dargestellten Ausführungsbeispiels näher erläutert.

Dabei zeigen:
Figur 1 eine schematische Draufsicht auf einen Bestückautomaten mit Zuführeinrichtungen und
Figur 2 eine schematische Draufsicht auf ein Bauelement.

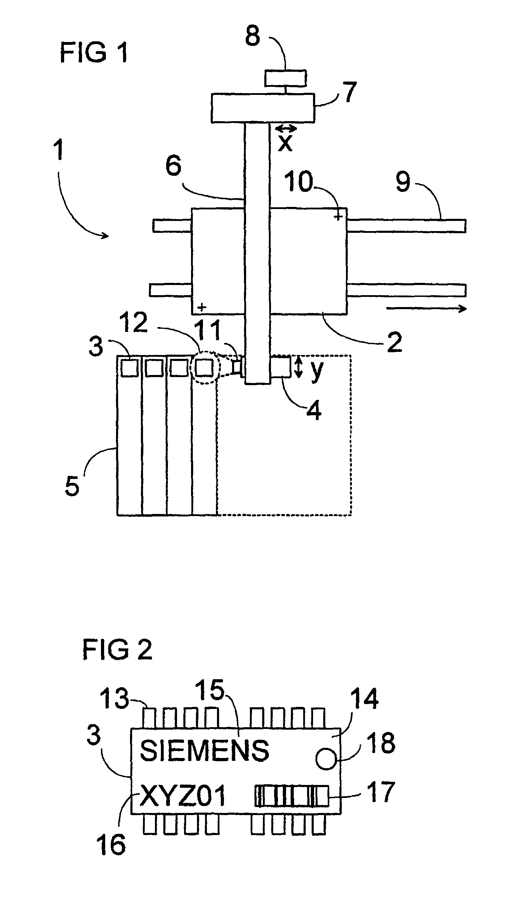

In Figur 1 ist ein Bestückautomat 1 für das Bestücken eines Substrats 2 (beispielsweise einer Leiterplatte oder eines Keramiksubstrates) dargestellt. Für die Bestückung werden die Bauelemente 3 mit Hilfe eines Bestückkopfes 4 aus einer Zuführeinrichtung 5 entnommen. Der Bestückkopf 4 wird mit Hilfe eines x-y-Portalsystems 6,7 über das Substrat 2 verfahren. Eine Steuereinrichtung 8 sorgt dafür, daß das Bauelement 3 auf eine vorher festgelegte Position auf dem Substrat 2 abgesetzt wird. Für den Transport weist der Bestückkopf 4 beispielsweise nicht dargestellte Saugpipetten auf, die mit Unterdruck das Bauelement 3 ansaugen und beim Absetzen wieder loslassen. Zusätzlich ist ein Transportsystem 9 dargestellt, auf dem das Substrat 2 durch den Bestückautomaten und zu weiteren, nicht dargestellten, Bearbeitungsautomaten (beispielsweise zum Bestücken mit weiteren Bauelementen) transportiert wird.

Die Zuführeinrichtungen 5 sind dabei als Bänder dargestellt, die Taschen aufweisen, in denen die Bauelement 3 transportiert und bereitgestellt werden. Es sind allerdings auch andere Zuführeinheiten wie beispielsweise Flächenmagazine bekannt, für die das erfindungsgemäße Verfahren ebenfalls anwendbar ist. Um zu erkennen, ob die richtigen Bauelemente 3 zugeführt werden, ist eine am Bestückkopf 4 angeordnete Kamera 11 vorgesehen, die innerhalb ihres Gesichtsfeldes 12 eine Abbildung des Bauelements 3 in der Zuführeinrichtung 5 aufnimmt. Eine der Kamera 11 nachgeschaltete nicht dargestellte Bildauswerteeinheit, die beispielsweise der Kamera 11 zugeordnet oder in der Steuereinrichtung 8 integriert sein kann, wertet das Bild aus. Dazu wird das Bild mit einem vorher in der Bildauswerteeinheit abgespeicherten Muster des Bauelementes 3 verglichen, welches gewisse Charakteristika des Bauelementes 3 beschreibt. Dazu gehören beispielsweise die Größe und die Form des Bauelementes aber auch, wie in Figur 2 dargestellt weitere Merkmale der Oberfläche 14 des Bauelementes 3. Zu diesen Merkmalen können gehören: Schriftzüge wie Firmenbezeichnungen oder Firmenlogos 15, Typenbezeichnungen 16 des Bauelementes 3, kodierte Kennzeichen 17 , wie Barcodes oder Matrixcodes, oder andere beispielsweise durch Laserbeschreibung aufgebrachte Markierungen 18. Auch die Position der Anschlüsse 13 am Bauelement 3 kann, soweit von oben erkennbar, im Muster hinterlegt sein und zur Auswertung herangezogen werden.

Anhand des Mustervergleichs, der mit an sich bekannten Verfahren zur Bildauswertung durchgeführt wird, ist nun einerseits zu erkennen, ob die richtigen Bauelemente 3 zur Verfügung stehen, was zur Entscheidung führt, ob der Bestückkopf 4 das Bauelement 3 aufnimmt und auf das Substrat 2 aufsetzt oder ob eine Fehlermeldung abgesetzt wird.

Bei bestimmten Mustermerkmalen ist darüber hinaus die Position des Bauelementes 3 in der Zuführeinrichtung 5 zu erkennen, wenn beispielsweise ein Winkel zwischen dem Bild des Schriftzuges 15 und dem Muster des Schriftzuges 15 erkannt wird. Diese Position, insbesondere Drehlage, kann dann bereits vom Bestückkopf 4 vor dem Abholen des Bauelementes 3 berücksichtigt werden, so daß dieser die Abholposition sicher anfährt.

Besonders geeignet für das Verfahren sind Kameras 11, die am Bestückkopf 4 angebracht sind und zusätzlich Substratmarkierungen 10 aufnehmen, anhand derer in der Bildauswerteeinheit die Lage des Substrats 2 vor dem Bestücken bestimmt wird.

Mit dem erfindungsgemäßen Verfahren ist dadurch eine automatische Rüstungskontrolle an Bestückautomaten 1 sichergestellt, die für unterschiedliche Zuführeinrichtungen 5 geeignet ist.

## Patentansprüche

1. Verfahren zur Rüstungskontrolle an Bestückautomaten (1) für das Bestücken von Substraten (2) mit Bauelementen (3) bei dem
ein Bild der Oberfläche eines zu bestückenden Bauelements (3) in einer Zuführeinrichtung (4) durch eine Kamera (11) aufgenommen wird,
das Bild in einer der Kamera (11) nachgeschalteten Bildauswerteeinheit mit einem eingespeicherten Muster des zu bestückenden Bauelementes (3) verglichen wird,
bei einem positiven Ergebnis des Vergleichs das Bauelement (3) auf das Substrat (2) bestückt wird und
bei einem negativen Ergebnis des Vergleichs eine Fehlermeldung darüber ausgegeben wird.

2. Verfahren zur Rüstungskontrolle an Bestückautomaten (1) nach Anspruch 1,
**dadurch gekennzeichnet,**
**daß** die Position des Bauelementes (3) in der Zuführeinrichtung (4) anhand des Vergleichs zwischen dem Bild und dem abgespeicherten Muster bestimmt wird.

3. Verfahren zur Rüstungskontrolle an Bestückautomaten (1) nach einem der Ansprüche 1 oder 2,
**dadurch gekennzeichnet,**
**daß** das Muster eine Beschreibung eines auf der Oberfläche (14) des Bauelementes (3) aufgebrachten Schriftzuges (15,16) enthält.

4. Verfahren zur Rüstungskontrolle an Bestückautomaten (1) nach einem der Ansprüche 1 bis 3,
**dadurch gekennzeichnet,**
**daß** das Muster eine Beschreibung eines auf der Oberfläche (14) des Bauelementes (3) aufgebrachten kodierten Kennzeichen (17) enthält.

5. Verfahren zur Rüstungskontrolle an Bestückautomaten (1) nach einem der Ansprüche 1 bis 4,
**dadurch gekennzeichnet,**
**daß** das Muster eine Beschreibung einer auf der Oberfläche (14) des Bauelementes (3) aufgebrachten Markierung (18) enthält.

6. Verfahren zur Rüstungskontrolle an Bestückautomaten nach einem der Ansprüche 1 bis 5,
**dadurch gekennzeichnet,**
**daß** das Muster eine Beschreibung der von oben zu erkennenden Position der Anschlüsse (13) des Bauelementes (3) enthält.

7. Verfahren zur Rüstungskontrolle an Bestückautomaten (1) nach einem der Ansprüche 1 bis 6,
**dadurch gekennzeichnet,**
**daß** eine an einem Bestückkopf (4) angebrachte Kamera (11) verwendet wird.

## Claims

1. Method of checking components in pick-and-place robots (1) for fitting substrates (2) with components (3), in which
an image of the surface of a component (3) to be fitted is recorded in a feed device (4) by a camera (11),
in an image evaluation unit connected downstream of the camera (11), the image is compared with a stored pattern of the component (3) to be fitted,
in the event of a positive result of the comparison, the component (3) is placed onto the substrate (2) and
in the event of a negative result of the comparison, an error message relating to this is output.

2. Method of checking components in pick-and-place robots (1) according to Claim 1, **characterized in that** the position of the component (3) in the feed device (4) is determined by using the comparison between the image and the stored pattern.

3. Method of checking components in pick-and-place robots (1) according to either of Claims 1 and 2, **characterized in that** the pattern contains a description of a line of text (15, 16) applied to the surface (14) of the component (3).

4. Method of checking components in pick-and-place robots (1) according to one of Claims 1 to 3, **characterized in that** the pattern contains a description of an encoded identifier (17) applied to the surface (14) of the component (3).

5. Method of checking components in pick-and-place robots (1) according to one of Claims 1 to 4, **characterized in that** the pattern contains a description of a marking (18) applied to the surface (14) of the component (3).

6. Method of checking components in pick-and-place robots according to one of Claims 1 to 5, **characterized in that** the pattern contains a description of the position, to be detected from above, of the terminals (13) of the component (3).

7. Method of checking components in pick-and-place robots (1) according to one of Claims 1 to 6, **characterized in that** use is made of a camera (11) fitted to a pick-and-place head (4).

## Revendications

1. Procédé destiné au contrôle de la présence de composants adéquats dans des robots (1) à planter des composants prévus pour l'équipement de substrats (2) avec des composants (3) et dans lequel
une image de la surface d'un composant (3) à planter est enregistrée par une caméra (11) dans un dispositif d'approche (4),
l'image est comparée, dans une unité d'évaluation d'images montée en aval de la caméra (11), à un spécimen mémorisé du composant (3) à planter,
si le résultat de la comparaison est positif, le composant (3) est planté sur le substrat (2) et,
si le résultat de la comparaison est négatif, un message d'erreur correspondant est émis.

2. Procédé destiné au contrôle de la présence de composants adéquats dans des robots (1) à planter des composants selon la revendication 1
**caractérisé par le fait**
**que** la position du composant (3) dans le dispositif d'approche (4) est déterminée à l'aide de la comparaison entre l'image et le spécimen enregistré.

3. Procédé destiné au contrôle de la présence de composants adéquats dans des robots (1) à planter des composants selon l'une des revendications 1 ou 2
**caractérisé par le fait**
**que** le spécimen renferme une description d'une inscription (15, 16) portée sur la surface (14) du composant (3).

4. Procédé destiné au contrôle de la présence de composants adéquats dans des robots (1) à planter des composants selon l'une des revendications 1 à 3
**caractérisé par le fait**
**que** le spécimen renferme une description d'une marque caractéristique codée (17) portée sur la surface (14) du composant (3).

5. Procédé destiné au contrôle de la présence de composants adéquats dans des robots (1) à planter des composants selon l'une des revendications 1 à 4
**caractérisé par le fait**
**que** le spécimen renferme une description d'un marquage (18) porté sur la surface (14) du composant (3).

6. Procédé destiné au contrôle de la présence de composants adéquats dans des robots (1) à planter des composants selon l'une des revendications 1 à 5
**caractérisé par le fait**
**que** le spécimen renferme une description de la position des bornes (13) du composant (3), qui peuvent être reconnues d'en haut.

7. Procédé destiné au contrôle de la présence de composants adéquats dans des robots (1) à planter des composants selon l'une des revendications 1 à 6
**caractérisé par le fait**
**qu'**on utilise une caméra (11) montée sur une tête à planter (4).
